# EUROPÄISCHE PATENTSCHRIFT

(11) **EP 2 267 462 B1**
(45) Veröffentlichungstag und Bekanntmachung des Hinweises auf die Patenterteilung: **16.10.2019**
(21) Anmeldenummer: 10005872.6
(22) Anmeldetag: 08.06.2010
(51) Int. Cl.: G01R 11/04, H02B 1/03, G01R 22/06

(54) **Adapterbaugruppe**
Adapter component
Composant d'adaptateur

(30) Priorität: 23.06.2009 DE 102009030255
(43) Veröffentlichungstag der Anmeldung: 29.12.2010
(73) Patentinhaber: Hager Electro GmbH & Co. KG, 66440 Blieskastel (DE)
(72) Erfinder: Kelaiditis, Konstantin, Dr., 66386 St. Ingberg (DE)
(74) Vertreter: Nuss, Laurent

(56) Entgegenhaltungen:
- EP-A2- 1 992 953
- WO-A1-2007/056878
- DE-A1- 10 261 206
- DE-A1-102004 056 580
- DE-U1- 9 409 410
- DE-U1-202005 017 605
- DE-U1-202009 003 921

## Beschreibung

Die Erfindung betrifft eine Adapterbaugruppe zur Anbringung an der Tragplatte einer Befestigungsleisten (Zählerkreuz) aufweisenden Zählerplatzinstallation, mit einer Befestigungs- und Kontaktiereinrichtung für einen elektronischen Stromzähler sowie einer Halteeinrichtung für zusätzliche Geräte, wobei an der Befestigungs- und Kontaktiereinrichtung und/oder Halteeinrichtung Mittel zur Ankopplung der Halteeinrichtung an die Befestigungs- und Kontaktiereinrichtung vorgesehen sind.

Aus der DE 20 2005 017 605 U1 geht eine solche Adapterbaugruppe hervor. Auf der Oberseite einer Anschlussleiste einer Befestigungs- und Kontaktiereinrichtung der Adapterbaugruppe sind Anschraubgewinde vorgesehen, an denen ein Gestell befestigt wird, das einen Schalter trägt. Für die Anschlussleiste und den Schalter ist eine gemeinsame Abdeckung vorgesehen.

Eine weitere Adapterbaugruppe für einen elektronischen Stromzähler geht aus der DE 102 61 206 B4 hervor. Die Adapterbaugruppe kann an die Stelle eines herkömmlichen elektro-mechanischen Stromzählers treten und lässt sich am Zählerkreuz der Zählertragplatte für den elektro-mechanischen Stromzähler befestigen. Die Halteeinrichtung dieser bekannten Adapterbaugruppe ist kastenartig ausgebildet und unmittelbar angrenzend an die Befestigungs- und Kontaktiereinrichtung für den elektronischen Stromzähler angeordnet.

Das Dokument EP 1 992 953 A2 beschreibt einen Zähleranschlussplatz mit einer Zählertragplatte zur Aufnahme von mindestens zwei Stromzählern. Das Dokument DE 10 2004 056 580 A1 beschreibt einen Halterbaustein für einen Zählerplatz.

Durch die vorliegende Erfindung wird eine Adapterbaugruppe der eingangs erwähnten Art dadurch weitergebildet, dass die Befestigungs- und Kontaktiereinrichtung eine Anschlussleiste für Stromkabel umfasst, für die eine durch Plombierung des elektronischen Stromzählers plombierbare Abdeckung vorgesehen ist, und die Ankopplungsmittel derart an der Befestigungs- und Kontaktiereinrichlung angeordnet sind, dass sie bei plombierter Abdeckung zugänglich sind.

Vorteilhaft lässt sich eine solche Adapterbaugruppe je nach den Erfordernissen mit oder ohne die Halteeinrichtung für die zusätzlichen Geräte einsetzen und bei Bedarf modular ausbauen. Für die Anwender entfallen überflüssige Aufwendungen.

In einer bevorzugten Ausführungsform der Erfindung umfasst die Befestigungs- und Kontaktiereinrichtung eine Anschlussleiste für Stromkabel, wobei eine die Befestigungs- und Kontaktiereinrichtung im Übrigen in Bezug auf die Anschlussleiste versetzt zu deren Längsmitte angeordnet ist. Der Eckbereich zwischen der Anschlussleiste und der übrigen Befestigungs- und Kontaktiereinrichtung lässt sich vorteilhaft für die Halteeinrichtung nutzen.

Zweckmäßig sind auch an dem seitlich Ober die übrige Befestigungs- und Kontaktiereinrichtung überstehenden Teil der Anschlussleiste Mittel zur Ankopplung der Halteeinrichtung vorgesehen.

Auch an einer der genannten Anschlussleiste abgewandten Seite der Befestigungs- und Kontaktiereinrichtung können Mittel zur Ankopplung der Halteeinrichtung vorgesehen sein.

Bei den Mitteln zur Ankopplung handelt es sich vorzugsweise um ein Steckelement und/oder eine Steckelementaufnahme. Insbesondere kann eine hinterschnittene Führung gebildet sein, in welche ein entsprechendes, mit der Halteeinrichtung oder/und der Befestigungs- und Kontaktiereinrichtung verbundenes Gegenstück eingreift.

Es ist für die Anschlussleiste eine durch Plombierung des elektronischen Stromzählers plombierbare Abdeckung vorgesehen. In der Grundausbaustufe der Adapterbaugruppe braucht daher nur einmal eine Plombierung vorgenommen zu werden.

In weiterer Ausgestaltung der Erfindung ist auch an der Oberseite der Befestigungs- und Kontaktiereinrichtung eine für den Anschluss gezählten Strom führender Kabel nutzbare Anschlussleiste gebildet, für die eine gesonderte, vorzugsweise plombier- und aufsteckbare, Abdeckung vorgesehen ist.

Die genannte Halteeinrichtung kann sich nach oben über die Oberseite der Befestigungs- und Kontaktiereinrichtung hinaus erstrecken und ggf. seitlich oberhalb der Befestigungs- und Kontaktiereinrichtung über diese hinweg erstrecken.

Auch für die Halteeinrichtung kann eine gesonderte Abdeckung vorgesehen sein, die vorzugsweise aufsteckbar und plombierbar ist.

In weiterer Ausgestaltung der Erfindung sind Einrichtungen zur Halterung eines Schnittstellenkabels in einer Parkposition vorgesehen.

Die Erfindung wird nachfolgend anhand eines Ausführungsbeispiels und der beiliegenden, sich auf dieses Ausführungsbeispiel beziehenden Zeichnungen näher erläutert. Es zeigen:
- Fig. 1: einen Grundbaustein einer Adapterbaugruppe nach der Erfindung,
- Fig. 2: die Adapterbaugruppe von Fig. 1 mit einer Abdeckung für eine Anschlussleiste,
- Fig. 3: die Adapterbaugruppe von Fig. 1 mit einer weiteren Abdeckung für eine Anschlussleiste,
- Fig. 4: die Adapterbaugruppe von Fig. 1 verbunden mit einer Halteeinrichtung für zusätzliche Geräte,
- Fig. 5: die Adapterbaugruppe in der Ausbaustufe von Fig. 4 mit einer zusätzlichen Abdeckung für die Halteeinrichtung mit den zusätzlichen Geräten,
- Fig. 6: eine weitere Ausbaustufe der Adapterbaugruppe von Fig. 1 mit einer sich oberhalb des Grundbausteins erstreckenden Halteeinrichtung, und
- Fig. 7: die Adapterbaugruppe in der Ausbaustufe von Fig. 6 mit einer Abdeckung für die Halteeinrichtung und die durch die Halteeinrichtung gehaltenen Zusatzgeräte.

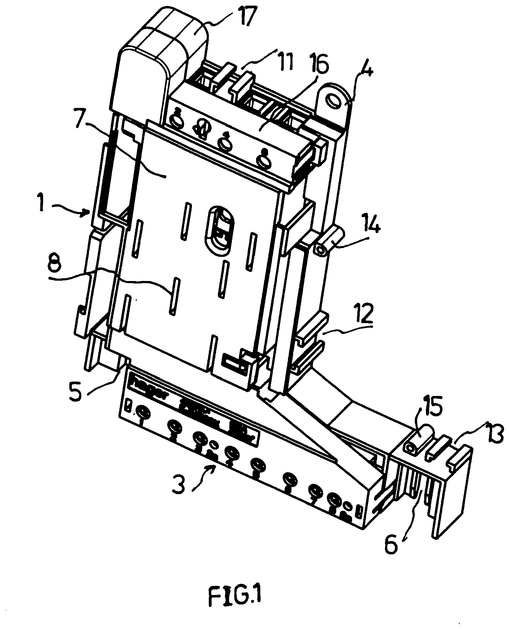

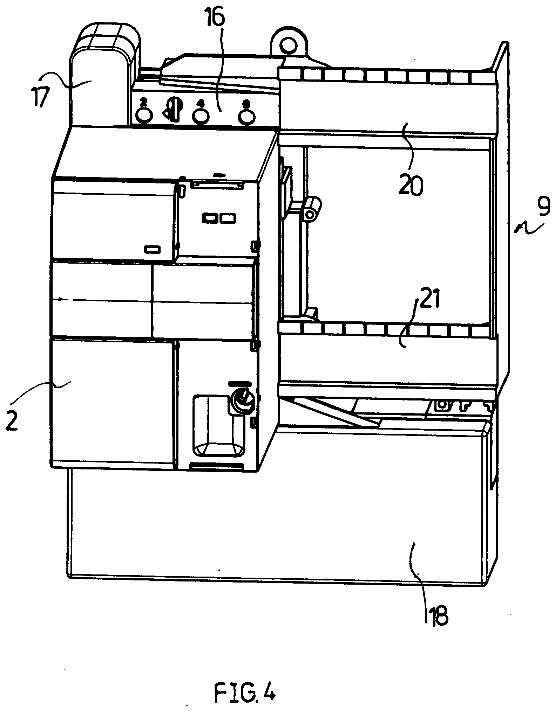

Eine in Fig. 1 gezeigte, einen Grundbaustein einer Adapterbaugruppe bildende Befestigungs- und Kontaktiereinrichtung 1 für einen elektronischen Stromzähler 2 (Fig. 4 bis 7) umfasst eine mit der übrigen Befestigungs- und Kontaktiereinrichtung verbundene Anschlussleiste 3 für den Anschluss von Stromkabeln. Eine Öse 4 dient der Befestigung der Adapterbaugruppe am vertikalen Schenkel eines Zählerkreuzes einer Zählerplatzinstallation für einen herkömmlichen Stromzähler. Über Befestigungsschlitze 5 und 6 kann die Adapterbaugruppe am horizontalen Schenkel des Zählerkreuzes befestigt werden, wobei die Anschlussleiste 3 symmetrisch zum vertikalen Schenkel und die übrige Befestigungs- und Kontaktiereinrichtung 1 seitlich versetzt dazu angeordnet sind.

Die Befestigungs- und Kontaktiereinrichtung 1 umfasst eine rechteckige Zöhlertragplatte 7 mit Öffnungsschlitzen 8, in die von dem Stromzähler 2 vorstehende Anschlusskontaktelemente (nicht sichtbar) einführbar und mit hinter der Zählertragplatte angeordneten Anschlussleiterstücken (nicht sichtbar) verbindbar sind.

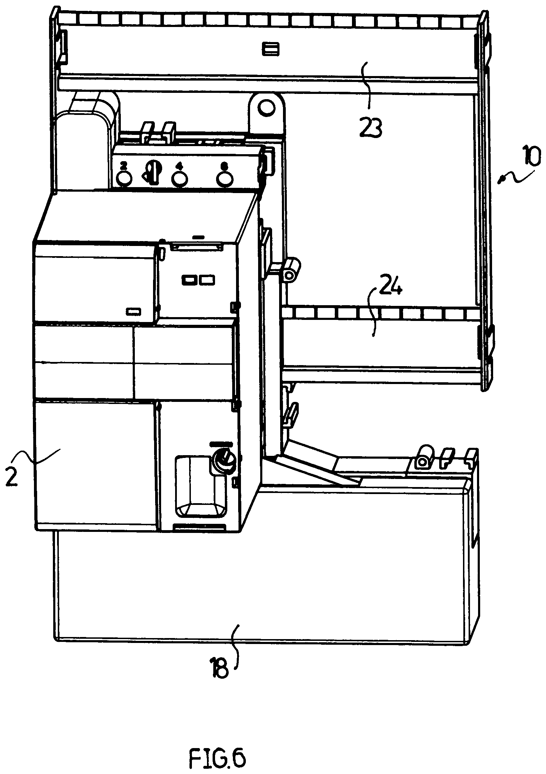

Die Befestigungs- und Kontaktiereinrichtung 1 weist sowohl an einer Längsseite als auch ihrer oberen Schmalseite Einrichtungen zur Ankopplung einer Halteeinrichtung für zusätzliche Geräte auf. Eine solche Einrichtung 9 ist in Fig. 4 und eine weitere solche Halteeinrichtung 10 in Fig. 6 gezeigt. Als Kopplungseinrichtungen dienen hinterschnittene Führungen 11 bis 13 sowie Vorsprünge 14 und 15 mit jeweils einer Befestigungsbohrung.

Die Befestigungs- und Kontaktiereinrichtung 1 weist an ihrer Oberseite ferner eine alternativ verwendbare Anschlussleiste 16 zum Anschluss nach oben wegführender Stromkabel auf, in denen gezählter Strom fließt. Ein im oberen Eckbereich der Befestigungs- und Kontaktiereinrichtung 1 angeordnetes Gehäuse 17 dient der Aufnahme eines mit dem Stromzähler 2 verbindbaren Schnittstellenkabels.

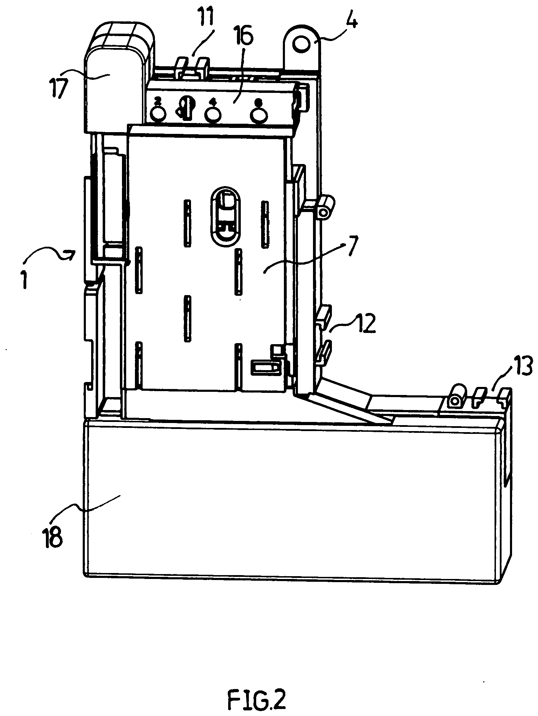

In einer in Fig. 2 gezeigten Ausbauvariante der Adapterbaugruppe wird nur die Befestigungs- und Kontaktiereinrichtung 1 und dessen Anschlussleiste 3 genutzt. Sowohl ungezählten als auch gezählten Strom führende Kabel sind von der Anschlussleiste 3 nach unten abgeführt. Eine den Zugang zu der Anschlussleiste verhindernde Abdeckung 18 ist durch Plombierung des Stromzählers gesichert, d.h. der auf der Zählertragplatte 7 aufsitzende Stromzähler 2 verhindert die Entnahme der Abdeckung 18 aus der in Fig. 2 gezeigten Position.

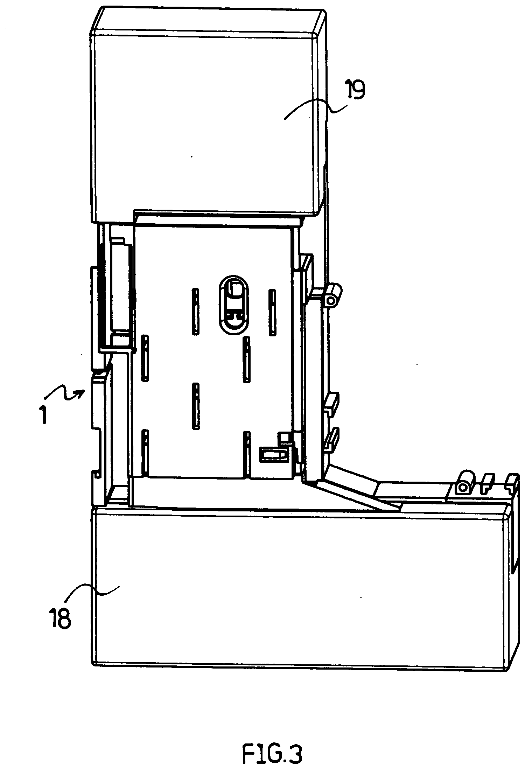

Aus Fig. 3 geht eine Ausbauvariante hervor, in welcher neben der durch die Abdeckung 18 abdeckbaren Anschlussleiste 3 auch die obere Anschlussleiste 16 genutzt wird. Die Anschlussleiste 16 ist durch eine aufsteckbare Abdeckung 19 verschließbar, wobei die Abdeckung 19 auch plombiert werden kann.

In der Ausbauvariante von Fig. 4 ist die rahmenartige Halteeinrichtung 9, die zwei sich horizontal erstreckende Hutprofilschienen 20 und 21 für die Aufnahme zusätzlicher Geräte umfasst, an die Befestigungs- und Kontaktiereinrichtung 1 angekoppelt.

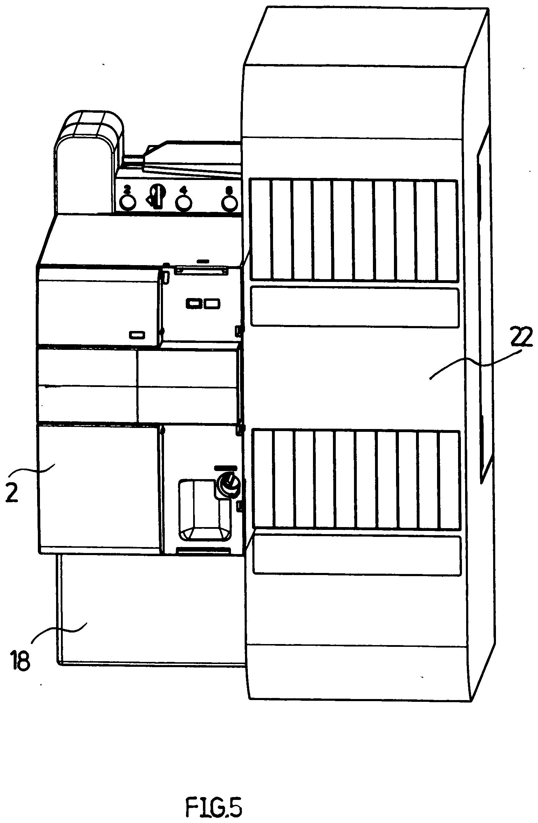

Wie aus Fig. 5 hervorgeht, ist für die Halteeinrichtung 9 und die durch diese gehaltenen Zusatzgeräte eine gesonderte Abdeckung 22 vorgesehen, die in dem gezeigten Ausführungsbeispiel auf die Adapterbaugruppe aufsteckbar und plombierbar ist.

Fig. 6 zeigt eine Ausbauvariante, in welcher sich die an die Befestigungs- und Kontaktiereinrichtung 1 angekoppelte Halteeinrichtung 10 nach oben über die Befestigüngs- und Kontaktiereinrichtung 1 hinaus erstreckt und neben einer Hutprofilschiene 23 eine sich über die gesamte Breite der Adapterbaugruppe erstreckende Hutprofilschiene 24 aufweist.

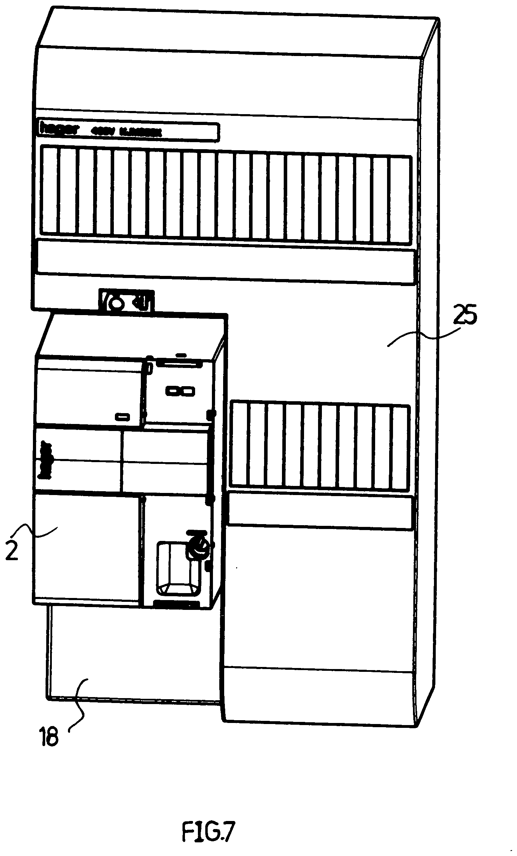

Wie aus Fig. 7 hervorgeht, ist für die Halteeinrichtung 10 und die diese haltenden Zusatzgeräte eine gesonderte Abdeckung 25 vorgesehen, die sich teilweise seitlich oberhalb der Befestigungs- und Kontaktiereinrichtung 1 erstreckt. Wie die Abdeckung 22 ist auch die Abdeckung 25 auf die Adapterbaugruppe aufsteckbar und plombierbar.

Das in dem Gehäuse 17 geparkte Schnittstellenkabel ist unabhängig vom Verschluss der Adapterbaugruppe durch die Abdeckung 22 oder 25 zur Herstellung einer Verbindung mit dem Stromzähler 2 verfügbar.

## Patentansprüche

1. Adapterbaugruppe zur Anbringung an der Tragplatte einer Befestigungsleisten (Zählerkreuz) aufweisenden Zählerplatzinstallation, mit einer eine Zählertragplatte (7) umfassende Befestigungs- und Kontaktiereinrichtung (1) für einen elektronischen Stromzähler (2) sowie einer Halteeinrichtung (9;10) für zusätzliche Geräte, wobei an der Befestigungs- und Kontaktiereinrichtung (1) und/oder der Halteeinrichtung (9;10) Mittel (11-15) zur Ankopplung der Halteeinrichtung (9;10) an die Befestigungs- und Kontaktiereinrichtung (1) vorgesehen sind,
**dadurch gekennzeichnet,**
**dass** die Befestigungs- und Kontaktiereinrichtung (1) eine Anschlussleiste (3) für Stromkabel umfasst, für die eine durch Plombierung des elektronischen Stromzählers (2) plombierbare Abdeckung (18) vorgesehen ist,
und die Ankopplungsmittel (11-15) derart an der Befestigungs- und Kontaktiereinrichtung (1) angeordnet sind, dass sie bei plombierter Abdeckung (18) zugänglich sind.

2. Adapterbaugruppe nach Anspruch 1,
**dadurch gekennzeichnet,**
**dass** die Befestigungs- und Kontaktiereinrichtung (1) eine Anschlussleiste (3) für Stromkabel umfasst und im Übrigen in Bezug auf die Anschlussleiste (3) in Längsrichtung der Anschlussleiste gesehen zu deren Mitte versetzt angeordnet ist.

3. Adapterbaugruppe nach Anspruch 2,
**dadurch gekennzeichnet,**
**dass** an einem seitlich über die übrige Befestigungs- und Kontaktiereinrichtung (1) überstehenden Teil der Anschlussleiste (3) Mittel (13) zur Ankopplung der Halteeinrichtung (9;10) vorgesehen sind.

4. Adapterbaugruppe nach Anspruch 3,
**dadurch gekennzeichnet,**
**dass** an einer der Anschlussleiste (3) abgewandten Seite der übrigen Befestigungs- und Kontaktiereinrichtung (1) Mittel (11) zur Ankopplung der Halteeinrichtung (9;10) vorgesehen sind.

5. Adapterbaugruppe nach einem der Ansprüche 1 bis 4.
**dadurch gekennzeichnet,**
**dass** die Mittel zur Ankopplung ein Steckelement oder/und eine Steckelementaufnahme umfassen, insbesondere in Form einer hinterschnittenen Führung (11-13) oder Bohrung (14;15).

6. Adapterbaugruppe nach einem der Ansprüche 3 bis 5,
**dadurch gekennzeichnet,**
**dass** für eine an der Oberseite der Befestigungs- und Kontaktiereinrichtung (1) vorgesehene, für den Anschluss gezählten Strom führender Kabel nutzbare weitere Anschlussleiste (16) eine gesonderte, vorzugsweise plombier- und aufsteckbare. Abdeckung (19) vorgesehen ist.

7. Adapterbaugruppe nach einem der Ansprüche 1 bis 6,
**dadurch gekennzeichnet,**
**dass** sich die Halteeinrichtung (10) nach oben über die Befestigungs- und Kontaktiereinrichtung (1) hinaus und ggf. seitlich oberhalb der Befestigungs- und Kontaktiereinrichtung (1) erstreckt.

8. Adapterbaugruppe nach einem der Ansprüche 1 bis 7,
**dadurch gekennzeichnet,**
**dass** für die Halteeinrichtung (9;10) eine gesonderte, vorzugsweise aufsteckbare und plombierbare Abdeckung (22;25), vorgesehen ist.

9. Adapterbaugruppe nach einem der Ansprüche 1 bis 8,
**dadurch gekennzeichnet,**
**dass** Einrichtungen (17) zur Aufnahme eines mit dem Stromzähler (2) verbindbaren Schnittstellenkabels vorgesehen sind.

## Claims

1. An adapter module for attaching to the support plate of a meter panel installation having fastening bars (meter cross support), with a fastening and contacting arrangement (1), comprising a meter support plate (7), for an electronic electricity meter (2), and also with a holding arrangement (9; 10) for additional equipment, wherein means (11 - 15) for coupling the holding arrangement (9; 10) to the fastening and contacting arrangement (1) are provided on the fastening and contacting arrangement (1) and/or the holding arrangement (9; 10),
**characterised in that**
the fastening and contacting arrangement (1) comprises a terminal bar (3) for electric cables, for which a covering (18) which can be sealed by sealing the electronic electricity meter (2) is provided,
and the coupling means (11 - 15) are arranged on the fastening and contacting arrangement (1) such that they are accessible when the covering (18) is sealed.

2. An adapter module according to Claim 1,
**characterised in that**
the fastening and contacting arrangement (1) comprises a terminal bar (3) for electric cables and moreover relative to the terminal bar (3), viewed in the longitudinal direction of the terminal bar, is arranged offset to the centre thereof.

3. An adapter module according to Claim 2,
**characterised in that**
means (13) for coupling the holding arrangement (9; 10) are provided on a part of the terminal bar (3) which projects laterally over the rest of the fastening and contacting arrangement (1).

4. An adapter module according to Claim 3,
**characterised in that**
means (11) for coupling the holding arrangement (9; 10) are provided on a side of the rest of the fastening and contacting arrangement (1) which is remote from the terminal bar (3).

5. An adapter module according to one of Claims 1 to 4,
**characterised in that**
the means for coupling comprise a plug-in element or/and a plug-in element receptacle, especially in the form of an undercut guide (11 - 13) or bore (14; 15).

6. An adapter module according to one of Claims 3 to 5,
**characterised in that**
a separate covering (19) which preferably can be sealed and placed on is provided for a further terminal bar (16) which is provided on the upper side of the fastening and contacting arrangement (1) and can be used for connecting cables carrying metered current.

7. An adapter module according to one of Claims 1 to 6,
**characterised in that**
the holding arrangement (10) extends upwards beyond the fastening and contacting arrangement (1) and possibly laterally above the fastening and contacting arrangement (1).

8. An adapter module according to one of Claims 1 to 7,
**characterised in that**
a separate covering (22; 25) which preferably can be placed on and sealed is provided for the holding arrangement (9; 10).

9. An adapter module according to one of Claims 1 to 8,
**characterised in that**
means (17) for receiving an interface cable which can be connected to the electricity meter (2) are provided.

## Revendications

1. Ensemble adaptateur destiné à être monté sur la plaque-support d'une installation de poste de comptage présentant des barrettes de fixation (croix de compteur), avec un dispositif de fixation et de contact (1) comprenant une plaque-support de compteur (7) pour un compteur électrique électronique (2) ainsi qu'un dispositif de retenue (9 ; 10) pour des appareils supplémentaires, des moyens (11-15) pour accoupler le dispositif de retenue (9 ; 10) au dispositif de fixation et de contact (1) étant prévus sur le dispositif de fixation et de contact (1) et/ou le dispositif de retenue (9 ; 10),
**caractérisé en ce**
**que** le dispositif de fixation et de contact (1) comprend une barrette de raccordement (3) pour des câbles électriques, pour laquelle est prévu un couvercle (18) pouvant être scellé par scellement du compteur électrique électronique (2), et les moyens d'accouplement (11-15) sont disposés sur le dispositif de fixation et de contact (1) de manière à être accessibles lorsque le couvercle (18) est scellé.

2. Ensemble adaptateur selon la revendication 1,
**caractérisé en ce**
**que** le dispositif de fixation et de contact (1) comprend une barrette de raccordement (3) pour des câbles électriques et est en outre disposé de manière décalée par rapport au centre de la barrette de raccordement (3), vu dans la direction longitudinale de la barrette de raccordement (3).

3. Ensemble adaptateur selon la revendication 2,
**caractérisé en ce**
**que** des moyens (13) pour l'accouplement du dispositif de retenue (9 ; 10) sont prévus sur une partie de la barrette de raccordement (3) qui dépasse latéralement du reste du dispositif de fixation et de contact (1).

4. Ensemble adaptateur selon la revendication 3,
**caractérisé en ce**
**que** des moyens (11) pour l'accouplement du dispositif de retenue (9 ; 10) sont prévus sur un côté du reste du dispositif de fixation et de contact (1) opposé à la barrette de raccordement (3).

5. Ensemble adaptateur selon l'une des revendications 1 à 4,
**caractérisé en ce**
**que** les moyens d'accouplement comprennent un élément enfichable et/ou un logement d'élément enfichable, en particulier sous la forme d'un guide à contre-dépouille (11-13) ou d'un alésage (14 ; 15).

6. Ensemble adaptateur selon l'une des revendications 3 à 5,
**caractérisé en ce**
**qu'**un couvercle (19) séparé, de préférence scellable et emboîtable, est prévu pour une autre barrette de raccordement (16) utilisable pour le raccordement de câbles conducteurs de courant compté et prévue sur le côté supérieur du dispositif de fixation et de contact (1).

7. Ensemble adaptateur selon l'une des revendications 1 à 6,
**caractérisé en ce**
**que** le dispositif de retenue (10) s'étend vers le haut au-delà du dispositif de fixation et de contact (1) et le cas échéant latéralement au-dessus du dispositif de fixation et de contact (1).

8. Ensemble adaptateur selon l'une des revendications 1 à 7,
**caractérisé en ce**
**qu'**un couvercle séparé (22; 25), de préférence emboîtable et scellable, est prévu pour le dispositif de retenue (9 ; 10).

9. Ensemble adaptateur selon l'une des revendications 1 à 8,
**caractérisé en ce**
**que** des dispositifs (17) sont prévus pour recevoir un câble d'interface pouvant être relié au compteur électrique (2).
